# EUROPEAN PATENT SPECIFICATION

(11) **EP 0 506 727 B1**
(45) Date of publication and mention of the grant of the patent: **26.06.1996**
(21) Application number: 91900815.1
(22) Date of filing: 19.12.1990
(51) Int. Cl.: H04B 1/26

(54) **A METHOD AND A DEVICE FOR RADIO RECEIVERS IF (INTERMEDIATE FREQUENCY) SIGNAL DETECTION**
VERFAHREN UND EINRICHTUNG ZUR ZF-SIGNALDETEKTION EINES EMPFÄNGERS
PROCEDE ET DISPOSITIF DE DETECTION DE SIGNAUX DE FREQUENCE INTERMEDIAIRE (F.I.) PROVENANT DE RECEPTEURS RADIO

(30) Priority: 20.12.1989 FI 896141
(43) Date of publication of application: 07.10.1992
(73) Proprietor: FINNTRACKER OY, SF-90460 Oulunsalo (FI)
(72) Inventor: Luoma, Ari-Matti, SF-90440 Kempele (FI)
(74) Representative: Seeger, Wolfgang, Dipl.-Phys.
(86) International application number: FI9000305
(87) International publication number: WO9109472

(56) References cited:
- PATENT ABSTRACTS OF JAPAN, Vol 7, No 272, E214, abstract of JP 58 153427, publ 1983-09-12 MATSUSHITA DENKI SANGYO K.K.
- PATENT ABSTRACTS OF JAPAN, Vol 7, No 258, E211, abstract of JP 58 142637, publ 1983-08-24 HITACHI SEISAKUSHO K.K.
- PATENT ABSTRACTS OF JAPAN, Vol 12, No 189, E616, abstract of JP 62 292029, publ 1987-12-18 NEC CORP

## Description

The object of the invention is a method and a device that uses this method for IF signal detection in a portable radio receiver that is specially used for tracking the location of a target object carrying a radio transmitter.

In receivers using a pulsed RF (radio frequency) signal as a carrier wave, a so called BEAT oscillator and a mixer for IF detection has usually been used. This kind of a prior art method has a mixer in the receiver after the last IF stage. The IF signal e.g. 455 kHz and the signal from the BEAT oscillator, e.g. 454 or 456 kHz, are mixed in that mixer. The mixing result is a 1 kHz LF (low frequency) signal which can be heard. The method described is used e.g. in devices that are tracking the location of animals by using a portable receiver to track a transmitter which is attached to an animal. In this kind of device the transmitter is small and cannot therefore be manufactured to be stable against ageing and temperature drifting.

One of the disadvantages of such a prior art method is that it is very sensitive to the frequency changes in the transmitting or the receiving end. If the frequency provided by the last IF stage changes (whatever the reason of the change is), the frequency of the receiver's BEAT-oscillator has to be changed accordingly, so that the mixer output signal will remain at 1 kHz. E.g. changes in temperature will cause drifting in the electronic components in the receiver and in the transmitter which will have an effect on the frequency.

In the prior art devices the frequency of the BEAT-oscillator is tuned manually with the receiver's tuning mechanism by listening to the tone. Manual tuning by listening to the tone is difficult and to be successful certain experience is needed from the user, who usually is not an expert in this field.

The published Japan patent application No 58-142637 discloses a frequency converting system of super heterodyne receiver, the purpose of which is to elevate stability in case of reception, by using a frequency difference between receiving frequency and the same frequency as fixed intermediate frequency oscillated by an oscillator, as a local oscillating signal of a frequency converting circuit. In this publication there is no mentioning neither of audible signal detection of a received intermediate frequency nor of any audible signal at all.

It is an object of the present invention to improve the audible detection of an IF signal.

This object is achieved by the features of claim 1.

According to the invention the IF signal to be detected is branched into two branches. The first branch signal is mixed with the second signal which has been derived from the second branch signal as follows. The second branch signal has been treated in a 90° phase shifting device, and the received sidebands are mixed with a LF oscillator signal fed through another 90° phase shifting device (i.e. in quadrature). The mixed sidebands are then fed to a summing device SA, in order to yield the second signal. This second signal is lead to the mixing device to be mixed with the first branched signal. This mixing produces an audible signal representing the IF signal to be detected. According to the solution of the present invention this audible signal remains constant despite fluctuations in the IF signal to be detected.

The following is an example where the invention is described by making references to the figures enclosed. The figures are
Fig. 1 Principle block diagram of a prior art method
Fig. 2 Block diagram describing the principles of the method of the object of the invention
Fig. 3 Block diagram of the method of the embodiment of the invention

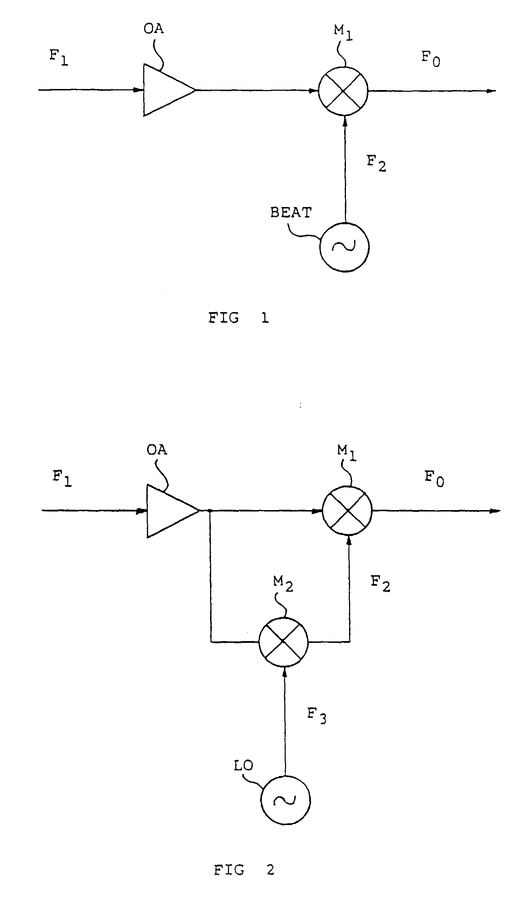

In the diagram in Fig. 1 the IF signal F1 from the receiver's last IF stage, e.g. 455 kHz, and the BEAT oscillator signal F2, e.g. 454 kHz (lower sideband), or 456 kHz (upper sideband), are routed to the mixer M1 inputs. Then the mixer M1 output will provide a 1 kHz LF signal which can be heard. If e.g. the IF signal F1 changes 1 kHz upwards or it is 456 kHz and the BEAT oscillator frequency remains unchanged at 454 kHz, the mixer M1 output will provide a 2 kHz LF signal. The error in the signal is 100% from desired 1 kHz. To compensate the situation the BEAT oscillator frequency must be tuned manually by listening to the tone.

Fig. 2 describes the principle of the new method of the invention. In the new method of the invention, the mixed signal F2 is produced using the IF signal F1 and signal F3 generated by the LO. Then the mixed signal F2 is tracking the changes in the IF signal F1 directly and the LF signal F0 which is detected from the IF signal F1 by the mixed signal F2 in mixer M1 will remain in it's desired constant value. In practice the circuit in fig. 2 will not work because the mixed signal F2 consists of both sidebands.

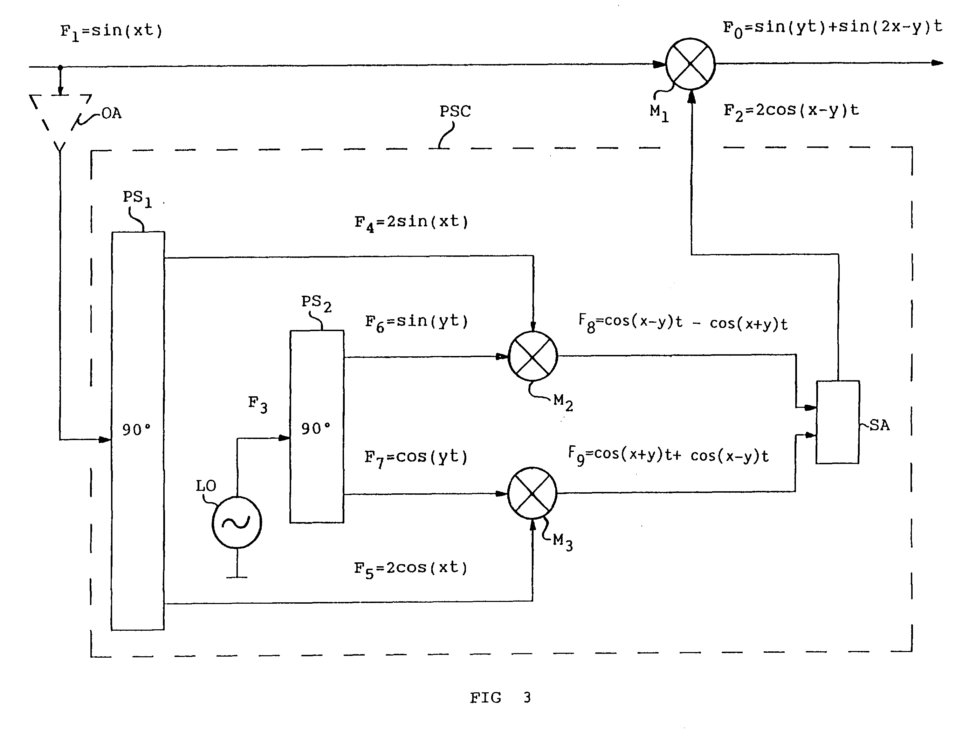

The method of the invention can be realized by using the circuit in fig.3. The principle of the phase shift circuit PSC in fig. 3 is priorly known from so called SSB (single-sideband suppressed carrier) technique where it is used in radio transceivers that send only one of the sidebands. Then the bandwidth required by one channel is reduced to the half.

In fig. 3 the IF signal F1 is routed to the input of a first mixer M1 and directly or through an amplifier OA to the input of a first 90 deg phase shift circuit PS1. Signal F4 from the output of the first phase shift circuit PS1 is in phase with the IF signal F1. Signal F4 is routed to the input of a second mixer M2 and the signal F5 from the first phase shift circuit PS1 which is 90 deg out of phase with the IF signal F1 are routed to the input of a third mixer M3. The LF signal F3 generated by a local oscillator LO is routed to the input of a second 90 deg phase shift circuit PS2. The signal F6 from the output of the second phase shift circuit PS2 is in phase with the LO- generated LF signal F3, and it is routed to the input of the second mixer M2. Signal F7 from the output of the second phase shift circuit PS2 is 90 deg. out of phase with the LF signal F3 and it is routed to the input of the third mixer circuit M3. Signals F8 and F9 from the outputs of the second M2 and the third M3 mixer are routed to the inputs of a summing amplifier SA, and the output of the summing amplifier SA is connected to the input of the first mixer M1.

In fig.3 there is a mathematical model which explains the functions of the circuitry by using trigonometric functions. Sin(xt) represents the IF signal F1 from the last IF stage. Sin(yt) represents the LF signal F3 which is generated by the local oscillator LO. At the mixer outputs M1, M2, M3 there is the product of the mixer input signals and at the output of the summing amplifier SA there is the sum of its input signals. In fig. 3 circuitry the mixed signal F2=2cos(x-y)t is detected from the lower sideband of the modulation result of the LO signal F3=sin(yt) and the IF signal F1=sin(xt) by using phase tracking.

If in fig. 3 either the outputs of the 90 deg phase shift circuit PS2 in the local oscillator circuit or the outputs of the 90 deg phase shift circuit PS1 are interchanged, the result will be that from the summing amplifier we will get the mixed signal F2=2sin(x+y)t which is the upper sideband.

E.g. in a receiver using pulsed RF (radio frequency) as a carrier wave and where IF signal is detected by using the method of the invention it is possible to use either sideband.

The way of presenting the invention in fig. 3 is not intended to limit the invention. It is also obviously possible to use other prior art phase tracking applications well known by a professional of this branch to realize the idea of this invention.

## Claims

1. A method for detecting an IF radio signal (F₁) as an audible signal (F₀) characterised by:
branching the IF signal into two branches;
passing the second branch signal through a first phase shift circuit (PS1) producing first (F₄) and second (F₅) IF output signals, whose phases differ by 90°;
passing a local oscillator signal (F₃) through a second phase shift circuit (PS2) producing first (F₆) and second (F₇) local oscillator output signals whose phases differ by 90°;
mixing the first IF output signal (F₄) with the first local oscillator output signal (F₆) to produce a first mixed product signal (F₈) and the second IF output signal (F₅) with the second local oscillator output signal (F₇) to produce a second mixed product signal (F₉);
summing the first and second mixed product signals (F₈, F₉) in a summing amplifier (SA) to a second signal (F₂); and
mixing this summed signal (F₂) with the first branch signal (F₁).

2. A method according to claim 1, characterized in that the frequency of the local oscillator signai (F₃) lies within such a distance from the frequency of the IF radio signal (F₁) that the combination of both frequencies yields an audible signal (F₀) of about 1 kHz.

3. A method according to claim 1 or 2, characterized in that for an IF radio signal F₁ = sin(xt)
the first IF output signal F₄ = 2sin(xt) and the second IF output signal F₅ = 2cos(xt),
the first local oscillator output signal F₆ = sin(yt) and the second local oscillator output signal F₇ = cos(yt),
the first mixed product signal of the respective first output signals F₈ = cos(x-y)t-cos(x+y)t and the second mixed product signal of the respective second output signals F₉ = cos(x+y)t +cos (x-y)t, and in that
the summed signal F₂ = 2cos(x-y)t,
which summed signal (F₂) is mixed with the first branch signal F₁ = sin(xt).

## Patentansprüche

1. Verfahren zum Detektieren eines IF-(Zwischenfrequenz)-Radiosignals (F1) als ein hörbares Signal (F0), gekennzeichnet durch:
Verzweigen des IF-Signals in zwei Zweige;
Hindurchführen des zweiten Zweigsignals durch eine erste Phasenschieberschaltung (PS1) die erste (F4) und zweite (F5) IF-Ausgabesignale erzeugt, deren Phasen um 90° differieren;
Hindurchführen eines zweiten lokalen Oszillatorsignals (F3) durch eine zweite Phasenschieberschaltung (PS2), die erste (F6) und zweite (F7) lokale Oszillatorausgabesignale erzeugt, deren Phasen um 90° differieren;
Mischen des ersten IF-Ausgabesignals (F4) mit dem ersten lokalen Oszillatorausgabesignal (F6), um ein erstes Mischproduktsignal (F8) zu erzeugen, und des zweiten IF-Ausgabesignals (F5) mit dem zweiten lokalen Oszillatorausgabesignal (F7), um ein zweites Mischproduktsignal (F9) zu erzeugen;
Summieren dieser ersten und zweiten Mischproduktsignale (F8, F9) in einem Summierverstärker (SA) zu einem zweiten Signal (F2); und Mischen diesen Summensignals (F2) mit dem ersten Zweigsignal (F1).

2. Verfahren nach Anspruch 1, dadurch gekennzeichnet, daß diese Frequenz des örtlichen Oszillatorsignals (F3) innerhalb eines solchen Abstandes von der Frequenz des IF-Radiosignals (F1) liegt, daß die Kombination beider Frequenzen ein hörbares Signal (F0) von etwa 1 KHz ergibt.

3. Verfahren nach Anspruch 1 oder 2, dadurch gekennzeichnet, daß für ein IF-Radiosignal F1 = sin(xt), wobei
das erste IF-Ausgabesignal F4 = 2sin(xt) und das zweite IF-Ausgabesignal F5 = 2cos(xt),
wobei das erste lokale Oszillatorausgabesignal F6 = sin(yt) und das zweite lokale Oszillatorausgabesignal F7 = cos(yt),
das erste Mischproduktsignal des entsprechenden ersten Ausgabesignals F8 = cos(x-y)t-cos(x+y)t und das zweite Mischproduktsignal des entsprechenden zweiten Ausgabesignals F9 = cos(x+y)t+cos(x-y)t, und das Summensignal F2 = 2cos(x-y)t,
welches Summensignal F2 mit dem ersten Zweigsignal F1 = sin(xt) gemischt wird.

## Revendications

1. Procédé pour détecter un signal radio FI (F₁) en tant que signal audible (F₀) caractérisé par les étapes suivantes :
- on divise le signal FI en deux branches ;
- on fait passer le second signal de branche à travers un premier circuit de déphasage (PS1) qui produit un premier et un second signal de sortie FI (F₄ ; F₅) dont les phases diffèrent de 90° ;
- on fait passer un signal d'oscillateur local (F₃) à travers un second circuit de déphasage (PS2) qui produit un premier et un second signal de sortie d'oscillateur local (F₆ ; F₇) dont les phases diffèrent de 90° ;
- on mélange le premier signal de sortie FI (F₄) avec le premier signal de sortie d'oscillateur local (F₆) pour produire un premier signal produit par mélange (F₈) et on mélange le second signal de sortie FI (F₅) avec le second signal de sortie d'oscillateur local (F₇) pour produire un second signal produit par mélange (F₉) ;
- on effectue la somme du premier et du second signal produit par mélange (F₈, F₉) dans un amplificateur de sommation (SA) en un second signal (F₂) ; et
- on mélange ce signal de sommation (F₂) avec le premier signal de branche (F₁).

2. Procédé selon la revendication 1, caractérisé en ce que la fréquence du signal d'oscillateur local (F₃) est située à l'intérieur d'une distance, depuis la fréquence du signal radio FI (F₁), telle que la combinaison des deux fréquences produit un signal audible (F₀) d'environ 1 kHz.

3. Procédé selon l'une ou l'autre des revendications 1 et 2, caractérisé en ce que pour un signal radio FI qui est F₁ = sin(xt)
- le premier signal de sortie FI est F₄ = 2sin(xt), et le second signal de sortie FI est F₅ = 2cos(xt),
- le premier signal de sortie d'oscillateur local est F₆ = sin(yt), et le second signal de sortie d'oscillateur local est F₇ = cos (yt),
- le premier signal produit par mélange des premiers signaux de sortie respectifs est F₈ = cos(x-y)t - cos(x+y)t, et le second signal produit par mélange des seconds signaux de sortie respectifs est F₉ = cos(x+y)t + cos(x-y)t, et en ce que
- le signal de sommation est F₂ = 2cos(x-y)t, ce signal de sommation (F₂) étant mélangé avec le premier signal de branche F₁ = sin(xt).
